# EUROPEAN PATENT SPECIFICATION

(11) **EP 0 584 030 B1**
(45) Date of publication and mention of the grant of the patent: **19.03.1997**
(21) Application number: 93480112.7
(22) Date of filing: 30.07.1993
(51) Int. Cl.: B01D 53/34, B01D 53/14

(54) **Process for the abatement of propylene carbonate emissions**
Verfahren zur Reduktion der Emission von Propylencarbonat
Procédé pour reduire l'émission de carbonate de propylène

(30) Priority: 04.08.1992 US 924769
(43) Date of publication of application: 23.02.1994
(73) Proprietor: International Business Machines Corporation, Armonk, N.Y. 10504 (US)
(72) Inventor: Ksenak, Gary S., Endicott, NY 13760 (US)
(74) Representative: Klein, Daniel Jacques Henri

(56) References cited:
- DE-A- 2 638 898
- DE-A- 3 903 975
- US-A- 5 006 369

## Description

The invention described herein relates to environmentally compatible developers and stripping solvents for photoresist materials. Specifically, the invention relates to cyclicalylene carbonates, as propylene carbonate, as substitutesfor such chlorinated solvents as Methyl Chloroform (MCF;1,1,1-Trichloroethane) and Methylene Chloride (MC;Dichloromethane).

Co pending application EP-A-582539 filed on the same day as this application relates to a Chemical Pre-Treatment and Biological Destruction of Propylene Carbonate Effluent Streams.

Even though propylene carbonate has a very low vapor pressure and a very high boiling temperature, parts per million levels of propylene carbonate can be present in the air surrounding stripping and developing processes utilizing propylene carbonate. According to the invention, the air surrounding propylene carbonate operations is scrubbed with a dilute, aqueous, alkaline solution. According to a further exemplification of the invention the scrubber liquor is monitored and its properties controlled. According to a still further embodiment of the invention the scrubber liquor overflow is mixed with the photolithographic effluents of cyclic alkylene carbonate solvents, e.g., propylene carbonate solvent, and sclids, e.g., photoresist and/or solder mask material, that are recovered from circuit panel manufacturing processes, and this combined liquid is treated to recover cyclic alkylene carbonate solvent.

Photolithographic processes in packaging are described in Microelectronics Packaging Handbook, Pub. Van Nostrand Reinhold, New York, 1989, Tummala et al, eds. on pages 898-903, in Principles of Electronic Packaging, McGraw-Hill Book Company, New York, 1989, Seraphim et al, eds. in Chapter 12, pages 372-393 and in Scientific Encyclopedia, 6th Ed., Vol. II, Pub. Van Nostrand Reinhold Company, New York, 1983, Considine et al, eds., pages 1877-1881, all of which are incorporated herein by reference for use as background.

Photolithography plays a critical role in the art of printed circuit packaging. Photolithography is used to define in a thin film of photoresist those regions either from which copper is to be selectively etched to subtractively form circuitization, or selectively plated to additively form circuitization.

There are two types of photoresist: negative and positive. A negative photoresist is polymerized by exposure, e.g., selective exposure to the particular actinic radiation radiation to which it is sensitive for an adequate period of time. It is than subjected to its developer. The developer solubilizes the areas of the resist which have not been exposed to actinic radiation. The areas of negative photoresist which have been exposed to actinic radiation are hardened by cross-linking and made more resistant to developer, relative to the unexposed regions.

Positive acting resists behave oppositely. Actinic radiation renders the positive acting photoresist more soluble in the developer, and the exposed regions are removed preferentially by a dilute alkaline developer.

Positive acting photoresists are used extensively to fabricate silicon devices, and for subtractive circuitization of printed circuit boards. However, positive photoresists, which are readily developed by dilute aqueous alkaline solutions and stripped by more concentrated aqueous alkaline solutions, perform poorly in high caustic environments and high temperatures.

The negative resists, on the other hand, are used when the circuit lines are provided by additive plating of copper, in areas where copper is desired, i.e., electroless or electroless plus electroplating, rather than by etching of copper away from where it is not desired.

Negative acting photoresists are cross-linked by the action of actinic energy on photoactive agents that form the free radicals or ionic groups necessary to initiate and/or support polymerization. Depending on their composition, commercially available photoresists are sensitive to UV radiation, X-rays, E-beams and so forth. The radiation may be furnished to the resist through a pattern in a mask, such as an emulsion mask or chrome mask, by contact or projection, or a beam of radiation may be rastered.

Negative acting photoresists include an organic resin binder, a photoinitiator/photosensitizer and a reactive monomer. Optionally, negative acting photo-resists also include fillers, for example, organic or inorganic fillers, fire retardants, plasticizers, dyes, flexibilizers, thermal stabilizers and other additives to improve the processing characteristics of the package.

Typical negative photoresist compositions include from 40 to 70% by weight of binder, 10 to 40% by weight of monomer, and 0.5 to 15% by weight of photoinitiator, to total 100% based on the weight of all these components.

An example of such compositions is described in US-A-4326010 (example 1).

In general negative-working resists are photopolymerizable materials of the type described in US-A-3469982, US-A-4273857 and US-A-4293635 and the photocrosslinkable species of the type disclosed in US-A-3526504.

Monomers which can be used either alone or in combination with others to form negative acting photoresists include: t-butyl acrylate, 1,5 pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Pat. 3,380,831, 2,2-di-(p-hydroxyphenyl)-propane diacrylate, pentaerythritol tetraacrylate, 2,2-di(p-hydrohyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate, ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene,1,4-benzenediol dimethacrylate, 1,4-diisopropenyl benzene, and 1,3,5-triisopropenyl benzene.

In addition to the monomers mentioned above, the photoresist material can also contain one or more free radical-initiated and polymerizable species with molecular weight of at least about 300. Monomers of this type are an alkylene or a polyalkylene glycol diacrylate and those described in US-A-2927022.

Free radical initiators which can be activated by actinic radiation which are thermally inactive at and below 185 degrees Centigrade include the substituted or unsubstituted polynuclear quinones listed in the following: 9,10-anthraquinone, 1-chloroanthraquinone, 2-chloroanthraquinone, 2-methylanthraquinone, 2-tert-butylanthraquinone, octamethylanthraquinone, 1,4-naphthoquinone, 9,10-phenanthrequinone, 1,2-benzanthraquinone, 2,3-benzanthraquinone, 2-methyl-1,4-naphthone, 2,3-dichloronaphthoquinone, 1,4-dimethylanthraquinone, 2,3-dimethylanthraquinone, 2-phenylanthraquinone, 2,3-diphenylanthraquinone, 2,3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione.

Other useful photoinitiators, of which some may be thermally active at temperatures lower than 85 degrees C, are described in US-A-2760863.

Dyes of a photoreducible nature and other reducing agents are described in US-A-2850445; 2875047; 3097096; 3074974; 3097097; and 3145104 as well as dyes of the phenazine, oxazine and quinone classes; Michler's ketone, benzophenone, 2,4,5-triphenylimidazolyl dimers with hydrogen donors, and mixtures thereof as described in US-A-3427161; 3479185 and 3549367 can be used as initiators. The cyclohexadienone compounds of US-A-4341860 are also useful as initiators. In addition sensitizers described in US-A-4162162 in combination with photoinitiators and photoinhibitors are useful.

Polymeric binders which can be used alone, or in combination with polymerizable monomers include the following: polyacrylate and alpha-alkyl polyacrylate esters, i.e. polymethyl methacrylate and polyethyl methacrylate; polyvinyl esters: i.e. polyvinyl acetate, polyvinyl acetate/acrylate, polyvinyl acetate/methacrylate and hydrolyzed polyvinyl acetate; ethylene/vinyl acetate copolymers; polystyrene polymers and copolymers, i.e. with maleic anhydride and esters; vinylidene chloride copolymers, i.e. vinylidene chloride/acrylonitrile; vinylidene chloride/methacrylate and vinylidene chloride/vinyl acetate copolymers; polyvinyl chloride and copolymers, i.e. polyvinyl chloride/acetate; saturated and unsaturated polyurethanes; synthetic rubbers, i.e. butadiene/acrylonitrile, acrylonitrile/butadiene/styrene, methacrylate/acrylonitrile/butadiene/styrene copolymers, 2-chlorobutadiene-1,3 polymers, chlorinated rubber, and styrene/butadiene/styrene, styrene/isoprene/styrene block copolymers; high molecular weight polyethylene oxides of polyglycols having average molecular weight from about 4,000 to 1,000,000; epoxides, i.e. containing acrylate or methacrylate groups; copolyesters; nylons or polyamides, i.e. N-methoxymethyl, polyhexamethylene adipamide; cellulose esters, i.e. cellulose acetate succinate and cellulose acetate butyrate; cellulose ethers, i.e. methyl cellulose, ethyl cellulose and benzyl cellulose; polycarbonates; polyvinyl acetal, i.e. polyvinyl butyral, polyvinyl formal; polyformaldehydes.

In addition to the polymeric binders listed above particulate thickeners such as described in US-A-3754920 i.e. silicas, clays, alumina, bentonites, kaolnites, and the like can be used.

Where aqueous developing of the photoresist is desirable the binder should contain sufficient acidic or other functionalities to render the composition processable in the aqueous developer. Suitable aqueous-processable binders include those described in US-A-3458311 and in US-A-4273856. Polymers derived from an aminoalkyl acrylate or methacrylate, acidic film-forming comonomer and an alkyl or hydroxyalkyl acrylate such as those described in US-A-4293635 can be included.

Normally a thermal polymerization inhibitor will be present to increase the stability during storage of the photosensitive compositions. Such inhibitors are; p-methoxy-phenol, hydroquinone, alkyl and aryl-substituted hydroqinones and quinones, tert-butyl catechol, pyrogallol, copper resinate, naphthylamines, beta-napthol, cuprous chloride, 2,6-di-tert-butyl-p-cresol, phenothiazine, pyridine, nitrobenzene and dinitrobenzene, p-toluequinone and chloranil. Also useful for thermal polymerization inhibitors are the nitroso compositions described in US-A-4168982.

Dyes and pigments may also be added to increase the visibility of the resist image. Any colorant used however, should be transparent to the actinic radiation used.

An example of such photosensitive compositions is described in Table I of US-A-4693959.

In the preparation of these formulations generally inert solvents are employed which are volatile at ordinary pressures. Examples include alcohols and ether alcohols, esters, aromatics, ketones, chlorinated hydrocarbons, aliphatic hydrocarbons, miscellaneous solvents such as dimethylsulfoxide, pyridine, tetrahydrofuran, dioxane, dicyanocyclobutane and 1-methyl-2-oxo-hexamethyleneimine, and mixtures of these solvents in various proportions as may be required to attain solutions. Antiblocking agents to prevent the coatings from adhering to the supporting files can also be included.

With some polymers, it is desirable to add a plasticizer, either solid or liquid, to give flexibility to the film or coating. Suitable plasticizers are described in US-A-3658543. A preferred liquid plasticizer is nolylphenoxypoly(ethyleneoxy)-ethanol. A preferred solid plasticizer is N-ethyl-p-toluenesulfonamide.

Photoimagable compositions are also utilized as solder masks. In such application a photoimagable composition is used by applying the composition to printed circuit board and followed by photolithographic techniques to expose various underlying features on the board while masking others. During the soldering process the solder will deposit onto the exposed underlying components. It is necessary that the solder mask material be formulated such that it can be applied by the appropriate methods, for example curtain coating. Suitable photoimageable compositions including many that use epoxies are described in the following US-A-4279985; 4458890; 4351708; 4138255; 4069055; 4250053; 4058401; 4659649; 4544623; 4684671; 4624912; 4175963; 4081276; 4693961; and 4442197.

More recently an improved cationically photoimageable solder mask is described in US-A-5026624 assigned to the assignee of the present application, disclosure of which is incorporated herein by reference. In fact US-A-5026624 teaches an improved photoimageable cationically polymerizable epoxy based coating material.

In processing negative working resists, unexposed areas of the imaged film are typically removed from the surface of a printed circuit board or substrate by action of a liquid developer in a spray form for a duration of several minutes or less. Depending on the particular type of photoresist composition the liquid developer may be a simple organic solvent, an aqueous solution of an inorganic base, or as described in US-A-3475171, a combination of organic solvent and aqueous base to form a semi-aqueous developer.

Methyl chloroform (MCF, 1,1,1-trichloroethane), and methylene chloride (MC, dichloromethane) are solvents which are widely used in the electronic packaging art and in other arts for developing and removing a number of photoresists which are otherwise resistant to chemical attack.

The highly alkaline electroless copper plating baths used in additive processes provide a harsh environment for photoresist. In general, the more chemically impervious resists are removable in an organic solvent such as methylene chloride. For less demanding chemical environments, aqueous developable photoresists may be adequate. The organically developable resists, however, continue to be used in an electroless copper environment and in the print band and thin film technologies in conjunction with acrylate-based resist such as DuPont's Riston T-168 and solvent processed solder masks such as the DuPont Vacrel 700 and 900 series, environments in which the aqueous resists are vulnerable.

The use of 1,1,1-trichloroethane and methylene chloride is disfavored because of growing environmental concerns over the effect of gaseous halogenated hydrocarbons on the depletion of earth's ozone layer and concerns over introducing suspected carcinogens to the atmosphere. Several countries have set goals for their total elimination. However, there continue to be many manufacturing processes in which use of resists which are aqueously developable simply is not feasible.

The industry therefore continues the search for organic solvents as alternates to 1,1,1-trichloroethane and methylene chloride. The new solvents must meet specific manufacturing and environmental requirements with respect to flammability, toxicity, ability to effect dissolution, shelf-life, waste disposal, ability to recycle, simplicity of composition, and compatibility with a spectrum of resists.

Alternative solvents for stripping solvent based Riston photoresists are also described in Research Disclosures, June 1989 p.302, published anonymously.

There have been previous attempts reported in the art to provide environmentally friendly alternatives to 1,1,1-trichloroethane and methylene chloride. However, none of the references describe the simple, environmentally acceptable, room temperature developer and stripper of the present invention.

In unpublished internal works conducted by N.R. Bantu et al, it has been demonstrated that the use of 4-methyl -1,2-dioxolan -2-one (propylene carbonate, methyl ethylene carbonate, 1,2-propylene carbonate) as a developer and as a stripping agent. This material has the structure:

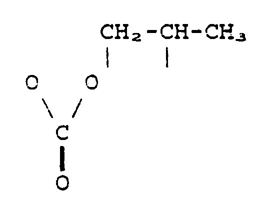

In addition, the use of this material as an alternative to halogenated hydrocarbon developers and strippers for use in developing and stripping acrylate based photoresist such as Riston T-168 and polymethyl methacrylate, and solvent processed solder marks such as the Vacrel 700 and 900 series. Moreover, developing the exposed resist in a high boiling solvent selected from the group consisting of propylene carbonate (PC), gamma butyrolactone (BLO) and benzyl alcohol (BA). The process occurs at about 24 to 45 degrees Centigrade for about 0.5-12 minutes and is normally followed by a warm water rinse or an alternate low boiling solvents rinse to remove excess developer.

While the common developers of the prior art for developing Riston type photoresists are low boiling point, high vapor pressure solvents, these solvents are high boiling solvents. The use of low boiling solvents such as methyl chloroform (MCF), methyl ethyl ketone (MEK), xylenes or mixtures thereof are similar to the methylene chloride stripping process.

By way of contrast high boiling solvents, i.e. n-methyl pyrolidone (NMP), gamma-butyrolactone (BLO), dimethyl sulfoxide (DMSO) and propylene carbonate (PC) must be followed by a rinsing step with compatible solvent or water. Furthermore, in order to obtain dissolution times comparable to those of MC, it is necessary that the temperature during stripping be maintained at above about 50 degrees Centigrade, and preferably between 50 degrees Centigrade and 100 degrees Centigrade. However, these thermal requirements result in the production of propylene carbonate laden fumes, with a propylene carbonate content in excess of 100 parts per million, and even as high as 2000 parts per million of propylene carbonate. The propylene carbonate must be removed from the air.

Thus, there is a clear need for a low cost process for the abatement of propylene carbonate fumes and the removal of propylene carbonate from the air.

It is a primary object of the invention to provide a simple, low cost process to remove propylene carbonate vapors from process gas streams and air in an emission abatement process.

It is a further object of the invention to control the parameters of the emission abatement process to keep the liquid streams strong enough to effectively scrub the propylene carbonate and permit economical equipment sizes, but dilute enough to allow for economical disposal or treatment.

The present invention removes the non-toxic solvents of the type described by Bantu et al from the air and process gas streams.

In order to obtain polymer dissolution times comparable to those of halogenated solvents with cyclic alkylene carbonates, as propylene carbonate, it is necessary that the temperature during developing be maintained as high as about 45 degrees Centigrade, and that the temperature during stripping be maintained above about 50 degrees Centigrade. Moreover, in order to get effective developing and stripping, it is necessary to use hot water to remove the cyclic alkylene solvent, such as propylene carbonate. Even though propylene carbonate is a low vapor pressure, high boiling temperature material, the use of temperatures above about 50 degrees Centigrade introduces the necessity of dealing with gaseous cyclic alkylene carbonates, for example, gaseous propylene carbonate, at least at the hundreds to thousands of parts per million level.

The gaseous cyclic alkylene carbonate, such as propylene carbonate, is scrubbed by removing the cyclic alkylene carbonate bearing air, as propylene carbonate bearing air, from the process, and passing the propylene carbonate bearing air through an aqueous alkaline liquid to scrub the cyclic alkylene carbonate, e.g., propylene carbonate, from the air. The scrubbed air, substantially free of cyclic alkylene carbonate, e.g., propylene carbonate, is recovered from the process. In a first embodiment of the invention the scrubbing liquor is biologically treated to destroy the residue.

In a further embodiment of the invention, both (i) scrubbed air substantially free of cyclic alkylene carbonates, e.g., propylene carbonate, and (ii) an alkaline liquor containing the residue of the scrubbed gaseous alkylene carbonate, e.g., propylene carbonate, are processed together to recover propylene carbonate for recycle.

This further embodiment includes feeding the propylene carbonate effluent and the alkaline liquor to a separator means, for example,an evaporator, and separating the water and volatiles from the propylene carbonate.

The dewatered propylene carbonate is evaporated to separate the propylene carbonate from high boiling materials and photoresist materials. This allows recovery of further purified propylene carbonate.

The further purified, that is, dewatered and evaporated propylene carbonate is separated into a high vapor pressure propylene glycol fraction and a low vapor pressure propylene carbonate fraction, for example, by fractional distillation.

The invention may be understood by reference to the FIGURES appended hereto.

FIGURE 1 is a flow chart of the cyclic alkylene carbonate air pollution abatement process of the invention.

FIGURE 2 is a plan view of a scrubber used in the method of the invention.

FIGURE 3 is a schematic view of a scrubber used in the method of the invention, further showing the process flows, and the control flows.

FIGURE 4 is a flow chart of an integrated process in which the emission abatement process is integrated into a cyclic alkylene carbonate solvent carbonate recovery process.

Cyclic alkylene carbonate laden air, such as propylene carbonate laden air, and impure liquid cyclic alkylene carbonate, as propylene carbonate, are effluents from an upstream industrial process in which relatively pure cyclic alkylene carbonate is used as either a developing agent or a stripping agent, or as both, in the removal of a thin film, layer, or coating of a polymeric material.

While the invention is described and illustrated with respect to propylene carbonate, 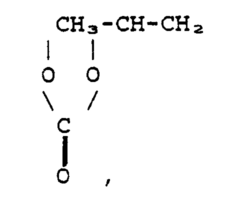 it is, of course, to be understood, that higher homologs of propylene carbonate, such as 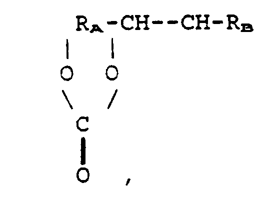 where one of R_{A} and R_{B} may be -H, and either one or both of R_{A} and R_{B} are short chain alkyl groups, may also be utilized in the practice of the invention. Exemplary short chain alkyl groups are CH₃-(CH₂)ₙ-, where n in R_{A} and R_{B} are independent integers from 0 to 3. It is, of course, further to be understood, that the vapor pressure of the cyclic alkylene carbonate must be high enough to allow fractionation or separation.

The impure propylene carbonate liquid contains photoresist products, including both dissolved polymer and dispersed solid polymer, as well as monomers, solvents, surfactants, fillers, initiators, dyes, and the like. This is referred to herein a "photoresist materials" and as "solids." The gas contains propylene carbonate at the parts per million level, for example from about one hundred or more parts per million to two thousand or more parts per million.

In one embodiment of the invention the polymer is a photoresist, for example, a negative photoresist formed of acrylic acid and acrylate ester moieties, such as Dupont Riston, and the liquid and gas effluents are the effluents of either or both of the developing and stripping steps. The polymer in the effluent liquid stream, whether in solution or dispersed, is included in the "photoresist materials" and referred to herein as "solids."

Propylene carbonate is evolved during fabrication of the electronic circuit package. Propylene carbonate gas evolution, notwithstanding the low vapor pressure and high boiling point of the propylene carbonate, is the result of washing the developed photoresist and the stripped electronic package with hot water. The propylene carbonate laden air is removed from the process, for example by fans, eductors, hoods, and the like.

For this reason, one effluent of the photolithographic process is a gaseous cyclic alkylene carbonate, such as propylene carbonate. While propylene carbonate is a low vapor pressure, high boiling temperature material (vapor pressure equals 0.08 torr at 80 degrees C, and 4.5 torr at 92 degrees C), the concentration of gaseous propylene carbonate in process gas streams and in air above the developing and stripping solutions can be from about 100 to about 500 parts per million above the developing solution, and from about 400 to about 1500 parts per million above the stripping solution. The propylene carbonate laden air is scrubbed by the action of an aqueous alkaline solution to yield air containing less than 100 parts per million of propylene carbonate.

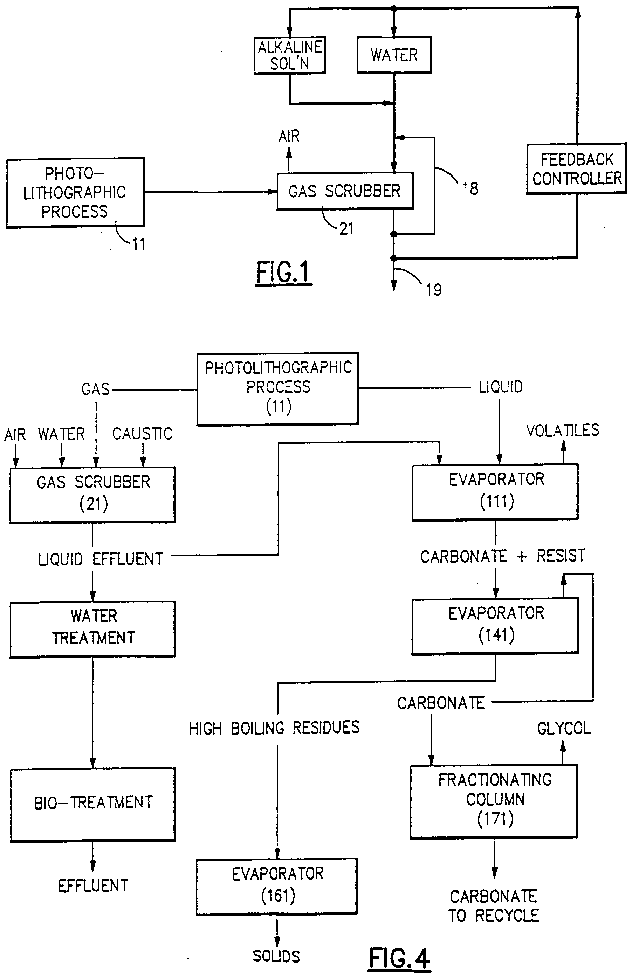

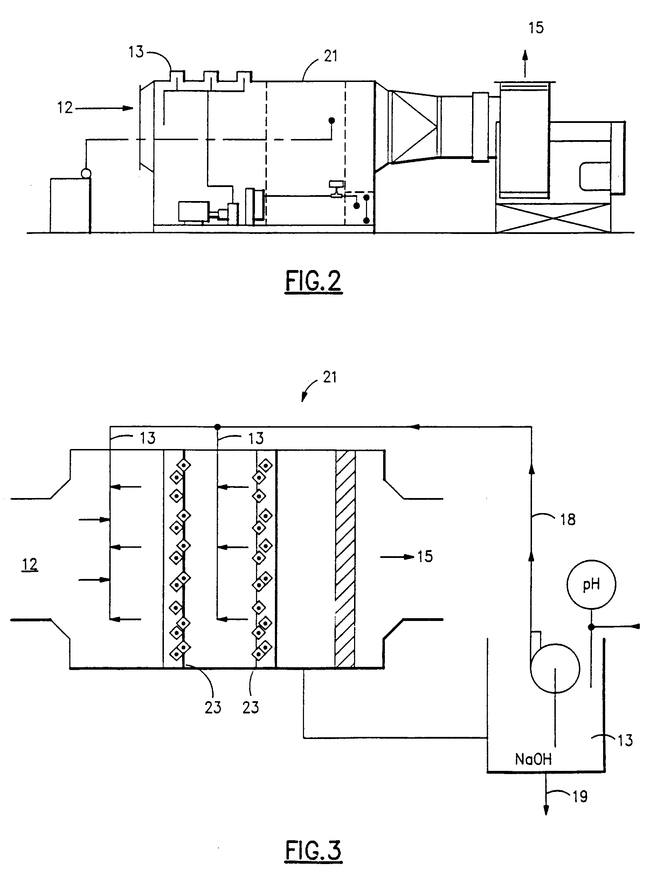

As shown in the flow chart in FIGURE 1 and in the schematic views of the process in FIGURES 2 and 3, the propylene carbonate laden air is passed through an aqueous alkaline liquid. The serves to scrub the propylene carbonate from the air. Scrubbed air is recovered from the scrubber. The scrubbed air is substantially free of propylene carbonate, containing less than 100 parts per million thereof.

FIGURE 1 is a flow chart of the front end of the process, i.e., the scrubber 21. FIGURES 2 and 3 show details of the scrubber. The scrubber 21 receives propylene carbonate laden air 12 from the manufacturing process 11. This gas feed goes into the scrubber 21, where it is contacted with a scrubbing solution 13, giving off clean air 15, and propylene carbonate containing solution 17, which may be recycled 18, or passed to a subsequent process 19.

Specifically, the input 12 to the scrubber 21 is propylene carbonate laden air containing more than 100 parts per million of propylene carbonate. The scrubbed gas product 15 from the scrubber 21 contains less than 100 parts per million of propylene carbonate.

The aqueous alkaline scrubbing agent is an aqueous solution of an alkali metal hydroxide or a salt of an alkali metal and a weak acid. For reasons of cost and availability, the alkali metal is either sodium or potassium, with sodium preferred. The anion is either hydroxide, or a weak acid, as carbonate, bicarbonate, or the like.

Preferably the alkali metal hydroxide is sodium hydroxide, the anion is hydroxide, and the aqueous sodium hydroxide solution contains less than 10 weight percent sodium hydroxide. This corresponds to a specific conductance of about 1-10 (ohm-cm)⁻¹, and a pH = 14.

The scrubbing solution is passed over or through a screen or packing 23. The screen or packing 23 provides turbulence, and increases the mass transfer coefficient. The aqueous, alkaline scrubbing solution may pass through the scrubber 23 once, or the scrubbing solution may be a circulating aqueous alkaline liquid with recycle and return 18, optionally with a bleed stream 19.

When the scrubbing solution is a circulating solution, it is necessary to monitor a property of the circulating solution, e.g., an electrolyte property of the circulating aqueous alkaline solution, in order to maintain a high mass transfer coefficient and driving force between the air and the solution. This is done by adjusting the concentrations of the electrolytes and water in the circulating aqueous alkaline solution, for example, by adding alkaline electrolyte or water responsive to the measured state of the solution. By the measured state of the solution is meant the pH or conductivity of the solution.

One way of controlling the chemistry of the solution is by measuring the pH of the solution and adjusting the concentration of the circulating aqueous alkaline solution responsive to the pH. For example, if the pH falls toward neutral, concentrated alkali metal ion make up solution can be dded to the circulating solution. Alternatively, if the pH becomes too alkaline, water can be added to the circulating solution. Alternatively, the electrical conductivity of the circulating solution can be measured, adjusting the concentration of the circulating aqueous alkaline solution in response to its conductivity. Thus, when the conductivity get soo high make-up water can be added, and when the conductivity falls too low concentrated make-up alkali can be added.

In a preferred embodiment of the invention the bleed stream 19 is chemically treated in a water treatment plant and thereafter biologically destroyed, as described, for example, in Ref. 1. However, in an alternative embodiment of the invention the bleed stream 19 can be processed with the liquid effluent of the photolithographic process for recovery of the propylene carbonate.

In the embodiment of the invention where the polymer is an acrylic-acrylate type photoresist and the solvent is propylene carbonate, the effluent of the photolithographic process contains (i) above abount 50 weight percent propylene carbonate, and generally from about 96 weight percent to about 99 weight percent of propylene carbonate, (ii) up to about 40 weight percent photoresist materials, and generally from about 0.2 weight percent to about 1.0 weight percent of "photoresist materials," i.e., "solids," that is, both dispersed solid polymer and dissolved, solubilized polymer, (iii) up to about 5 weight percent, and generally from about 0.1 weight percent to about 0.5 weight percent of propylene glycol, a hydrolysis decomposition product of propylene carbonate, and (iv) up to about 5 weight percent, and generally from about 0.1 weight percent to about 2.5 weight percent of water. These weight percentages should total 100 weight percent, but may total less than 100 weight percent if other impurities are present.

In order to recycle the cyclic alkylene carbonate, e.g., propylene carbonate, for reuse as a developing agent or stripping agent, it is necessary to recover a purified cyclic alklyene carbonate, e.g., propylene carbonate. By purified propylene carbonate is generally meant a propylene carbonate product that is substantially free of solids, i.e., less than 0.1 percent water, and preferably less than 0.050 weight percent water, and less than 0.05 weight percent propylene glycol as evidenced by a color value of less than 20 APHA (reference to platinum-cobalt standard).

FIGURE 4 is a flow chart for for a further embodiment of the invention where both the gaseous effluent and a liquid effluent are recovered. The gaseous effluent, containing from about 20 to about 500 parts per million of propylene carbonate, is first scrubbed, as described above. This yields a scrubbed air stream containing less than 100 parts per million of propylene carbonate, and an aqueous, alkaline solution containing propylene carbonate. This scrubber liquor stream is mixed with the aqueous propylene carbonate effluent of propylene carbonate, water, and polymeric solids stream. The system illustrated in FIGURE 4 also includes provision for water treatment and biological destruction of the liquid effluent 19 of the gas scrubber 11.

In the recovery process illustrated in FIGURE 4 the propylene carbonate effluent, both directly from the photolithographic process and indirectly from the photolithographic process via the gas scrubber, is fed to a first separation stage, 111. In the first separation stage the effluent stream is separated into two streams, (i) a gaseous stream of water and volatiles recovered at the top of the first separation stage 111, and (ii) a liquid propylene carbonate stream.

This first stage separation lowers the concentration of water in the cyclic alkylene carbonate solvent effluent, e.g., propylene carbonate, to a level that is low enough to substantially avoid hydrolysis of the cyclic alkylene carbonate, such as propylene carbonate, to the corresponding glycol, such as propylene glycol. The first stage separator may be a heat exchanger type evaporator 111. In the first stage evaporator the total pressure is maintained above the vapor pressure of propylene carbonate at its open cup flash point. This corresponds to a temperature of 132 degrees Centigrade.

The bottom product of the first separation stage is dewatered propylene carbonate, preferably containing (i) from about 96 weight percent to about 99 weight percent of propylene carbonate, (ii) from about 0.2 weight percent to about 0.5 weight percent of "solids," that is, both dispersed solid polymer and dissolved, solubilized polymer, (iii) from about 0.1 weight percent to about 0.5 weight percent of propylene glycol, and (iv) from about 0.08 weight percent to about 0.10 weight percent of water, the concentrations totalling 100 weight percent.

The dewatered propylene carbonate from the first stage separation 111 is further separated in a second stage separation 141 to separate the propylene carbonate from high boiling materials and polymeric solids, for example, by evaporation. In the second stage separation, 141, the dewatered propylene carbonate is separated into (i) a propylene carbonate fraction, and (ii) a polymeric solids fraction. The polymeric solids fractions contains polymeric material in propylene carbonate.

The pressure in the evaporator 41 is maintained below about 25 torr, for example at about 5 to about 15 torr. The temperature in the evaporator 41 is maintained above about 120 degrees Centigrade.

The second stage separation 141 yields an overhead product of about 98 to about 99 weight percent propylene carbonate and a bottom product of polymeric material in propylene carbonate.

The overhead product of the second stage separation 141, that is the evaporated, dewatered propylene carbonate, is fed to a fractionation means 171. This fractionation means 171 is used to further separate the evaporated, dewatered propylene carbonate into a higher vapor pressure propylene glycol fraction and a lower vapor pressure propylene carbonate fraction.

Optionally, propylene carbonate may also be recovered from the bottom product of the second stage. The bottom product is polymeric material in propylene carbonate. The bottom product contains from about 94 to about 97 propylene carbonate, balance solids. According to this alternative method of the invention, the bottom product of the evaporator 141 is fractionated, e.g., in a fractionation column.

The product of the fractionation step, 171, is a fractionated product that is substantially free of polymeric materials. By being substantially free of polymeric materials is meant that the propylene carbonate product has a color value less than 20 APHA (reference to platinum-cobalt standard). The fractionated product is also substantially free of water, containing less than 0.050 weight percent water.

To recover an overhead product, in an associated condenser, of propylene glycol, and a bottom product, in an associated evaporator or pot, of high purity propylene carbonate, without degradation of the propylene carbonate the column pressure must be carefully maintained. Preferably the top pressure of the fractionation means 171 is less than 20 torr, and from about 5 to about 7 torr, and the bottom pressure is less than about is less than 10 torr.

Critical to a high recovery of high purity propylene carbonate, is the minimal in process loss of the propylene carbonate. Propylene carbonate is not just lost with the solids. It is also lost chemically, for example, through the formation of by-products and hydrolysis products.

The control of these in-process loss pathways requires low operating temperatures, minimal times at higher temperatures, and the substantial absence of water. The operating temperature and the exposure time to heat input surfaces are held to a minimum to slow the rate of decomposition of propylene carbonate.

Low temperature and low exposure times to heat transfer surfaces both necessitate processing under substantial vacuum conditions. Substantial vacuum conditions reduce and even eliminate the need to heat the cyclic alkylene carbonate streams, for example, propylene carbonate streams, to high temperatures. An upper temperature that appears to avoid adverse by-products is 160 degrees Centigrade. A convenient design and operating temperature limit is the open cup flash point of the cyclic alkylene carbonate. For propylene carbonate the open cup flash point is 132 degrees Centigrade. In the case of propylene carbonate, processing below the 132 degree Centigrade open cup flash point makes it possible to minimize combustion and explosion concerns. This mitigates the need for damage limiting construction, as well as flame proof and explosion proof recovery equipment. Additionally, low temperatures reduce the rate of decomposition.

Moreover, if water is removed early in the process sequence it is possible to minimize decomposition of the propylene carbonate, for example by hydrolysis. These considerations drive the process sequence shown in FIGURE 4 and in the individual process steps shown below.

## Claims

1. A method of fabricating an electronic circuit package comprising the steps of depositing photoresist onto the circuit package substrate, imaging the photoresist, developing the photoresist, circuitizing the substrate, and stripping the remaining photoresist, wherein the solvent for one or both of developing the resist and stripping the resist is a cyclic alkylene carbonate, and wherein gaseous solvent is evolved during fabrication of the electronic circuit package, said process including the further steps of
a. removing the solvent bearing fumes from the process;
b. passing the solvent bearing fumes through an aqueous alkaline liquid to scrub the solvent therefrom; and
c. recovering scrubbed air substantially free of solvent.

2. The method of claim 1 wherein said cyclic alkylene carbonate consists of propylene carbonate.

3. The method of claim 2 wherein the propylene carbonate bearing fumes contain more than 100 parts per million of propylene carbonate, and the scrubbed gas contains less than 100 part per million propylene carbonate.

4. The method claim 2 or 3 wherein the aqueous alkaline liquid is a solution of an alkali metal hydroxide or a salt of an alkali metal and a weak acid.

5. The method of claim 4 wherein the alkali metal hydroxide is sodium hydroxide, and the aqueous sodium hydroxide solution contains less than 10 weight percent sodium hydroxide.

6. The method of claim 4 where the aqueous alkaline liquid is a circulating aqueous alkaline liquid, comprising :
a. monitoring an electrolyte property of the circulating aqueous alkaline solution; and
b. adjusting the concentration of the circulating aqueous alkaline solution by adding alkaline electrolyte or water responsive to the state of the solution.

7. The method of claim 6 comprising measuring the pH of the solution and adjusting the concentration of the circulating aqueous alkaline solution by adding alkaline electrolyte or water responsive to the pH of the solution.

8. The method of claim 6 comprising measuring the electrical conductivity of the solution and adjusting the concentration of the circulating aqueous alkaline solution by adding alkaline electrolyte or water responsive to the conductivity of the solution.

9. A method of recovering a cyclic alkylene carbonate from a process in which the cyclic alkylene carbonate is a solvent used to remove an organic polymeric material from a substrate and thereby form a gaseous cyclic alkylene carbonate effluent stream and an aqueous effluent stream, said method comprising the steps of :
a. recovering the gaseous cyclic alkylene carbonate effluent from the process;
b. passing the gaseous cyclic alkylene carbonate through an aqueous alkaline liquid to scrub the cyclic alkylene carbonate therefrom;
c. withdrawing (i) scrubbed air substantially free of cyclic alkylene carbonate, and (ii) an alkaline liquor containing the residue of the scrubbed gaseous cyclic alkylene carbonate;
d. feeding the cyclic alkylene carbonate effluent and the alkaline liquor to a separation means and separating water and volatiles from the cyclic alkylene carbonate;
e. recovering the dewatered cyclic alkylene carbonate and thereafter evaporating the dewatered cyclic alkylene carbonate to separate the cyclic alkylene carbonate from high boiling materials and polymeric solids, and recovering therefrom a cyclic alkylene carbonate fraction; and
f. futher separating the evaporated, dewatered cyclic alkylene carbonate into a high vapor pressure cyclic alkylene glycol fraction and a low vapor pressure cyclic alkylene carbonate fraction.

10. The method of claim 9 comprising removing water to lower the concentration thereof low enough to substantially avoid hydrolysis of cyclic alkylene carbonate to alkylene glycol.

11. The method of claim 9 or 10 comprising recovering the dewatered cyclic alkylene carbonate and thereafter evaporating the dewatered cyclic alkylene carbonate from contained polymeric materials.

12. The method of claim 11 comprising recovering an overhead product of cyclic alkylene carbonate and a bottom product of polymeric material in alkylene carbonate.

13. The method of any above claim 11 to 12 comprising feeding the evaporated, dewatered cyclic alkylene carbonate to a fractionation means, and further separating the evaporated, dewatered cyclic alkylene carbonate into a higher vapor pressure alkylene glycol fraction and a lower vapor pressure nnp carbonate fraction.

14. The method of claim 13 comprising recovering a fractionated product, substantially free of polymeric materials, having a color value less than 20 APHA reference to platinum-cobalt standard).

15. The method of claim 13 comprising recovering actionated product containing less than 0.050 weight percent water.

16. The method of any above claim wherein the cyclic alkylene carbonate is represented by the formula 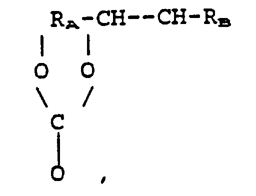 where one or both of Ra and Rb are short chain alkyl groups chosen from the group consisting of CH3-(H2)n-, where n and Ra and Rb are independent integers from 0 to 3, and one of Ra and Rb may be - H.

17. The method of claim 14 wherein the short chain alkylene carbonate is propylene carbonate.

18. The method of claim 17 comprising removing water to lower the concentration thereof low enough to substantially avoid hydrolysis of propylene carbonate to propylene glycol.

19. The method of claim 16 comprising recovering the dewatered propylene carbonate and thereafter evaporating the dewatered propylene carbonate to separate the propylene carbonate from contained polymeric materials.

20. The method of claim 19 comprising recovering an overhead product of propylene carbonate and a bottom product od polymeric material is a solubilizing amount of propylene carbonate.

21. The method of any above claim 18 to 19 comprising feeding the evaporated, dewatered propylene carbonate to a fractionation means, and further separating the evaporated into a high vapor pressure propylene glycol fraction and a low vapor pressure propylene carbonate fraction.

22. The method of claim 21 comprising recovering a fractionated product substantially free of polymeric materials, having a color value less than 20 APHA (reference to platinum-cobalt standard).

23. The method of claim 21 comprising recovering a fractionated product substantially free of water, containing less than 0.030 weight percent water.

## Patentansprüche

1. Verfahren zur Fertigung elektronischer Kompaktschaltungen bestehend aus den folgenden Verfahrensschritten: Aufbringen eines Photolacks auf das Kompaktschaltungssubstrat, Aufbringen eines Musters auf den Photolack, Entwickeln des Photolacks, Herstellung der Schaltung auf dem Substrat und Abziehen des restlichen Photolacks, wobei die Lösung für das Entwickeln des Photolacks und/oder Abziehen des Photolacks ein zyklisches Alkylencarbonat ist, und wobei sich das gasförmige Lösungsmittel während der Fertigung der Kompaktschaltung entwickelt, und wobei der Prozeß die folgenden weiteren Schritte enthält:
a. Abführen der Lösungsmittel enthaltenden Gase aus dem Prozeß;
b. Durchleiten der Lösungsmittel enthaltenden Gase durch eine wäßrige alkalische Flüssigkeit zum Auswaschen des Lösungsmittel aus diesen; und
c. Wiedergewinnen gereinigter Luft, die im wesentlichen frei von Lösungsmittel ist.

2. Das Verfahren gemäß Anspruch 1, in dem das zyklische Alkylencarbonat aus Propylencarbonat besteht.

3. Das Verfahren gemäß Anspruch 2, in dem die Propylencarbonat-enthaltenden Gase mehr als 100 ppm Propylencarbonat enthalten und das ausgewaschene Gas weniger als 100 ppm Propylencarbonat enthält.

4. Das Verfahren gemäß Anspruch 2 oder 3, in dem die wäßrige alkalische Flüssigkeit eine Lösung eines Alkalimetallhydroxids oder ein Salz eines Alkalimetalls und einer schwachen Säure ist.

5. Das Verfahren gemäß Anspruch 4, in dem das Alkalimetallhydroxid Natriumhydroxid ist, und die wäßrige Natriumhydroxidlösung weniger als 10 Gew.% Natriumhydroxid enthält.

6. Das Verfahren gemäß Anspruch 4, in dem die wäßrige akalische Flüssigkeit eine umlaufende wäßrige alkalische Flüssigkeit ist, und das umfaßt:
a. Überwachen einer elektrolytischen Eigenschaft der umlaufenden wäßrigen alkalischen Lösung; und
b. Einstellen der Konzentration der umlaufenden wäßrigen alkalischen Lösung durch Beifügen eines alkalischen Elektrolyts oder von Wasser, je nach Zustand der Lösung.

7. Das Verfahren gemäß Anspruch 6, enthaltend das Messen des pH-Werts der Lösung und Einstellen der Konzentration der umlaufenden wäßrigen alkalischen Lösung durch Beifügen eines alkalischen Elektrolyts oder von Wasser, je nach pH-Wert der Lösung.

8. Das Verfahren gemäß Anspruch 6, enthaltend das Messen der elektrischen Leitfähigkeit der Lösung und Einstellen der Konzentration der umlaufenden alkalischen Lösung durch Beifügen eines alkalischen Elektrolyts oder von Wasser, je nach der Leitfähigkeit der Lösung.

9. Ein Verfahren zum Wiedergewinnen eines zyklischen Alkylencarbonats aus einem Prozeß, in dem das zyklische Alkylencarbonat ein Lösungsmittel ist, das zum Entfernen eines organischen polymeren Stoffes von einem Substrat benutzt wird und dabei einen gasförmigen zyklischen Alkylencarbonat-Abgasstrom und einen wäßrigen Abflußstrom bildet, wobei das Verfahren die folgenden Schritte aufweist:
a. Wiedergewinnen des gasförmigen zyklischen Alkylencarbonat-Abflußstrom aus dem Prozeß;
b. Leiten des gasförmigen zyklischen Alkylencarbonats durch eine wäßrige alkalische Flüssigkeit zum Auswaschen des zyklischen Alkylencarbonats aus dieser;
c. Abziehen von (i) gewaschener Luft, die im wesentlichen frei von zyklischem Alkylencarbonat ist, und (ii) einer alkalischen Lauge, die den Rest des ausgewaschenen gasförmigen zyklischen Alkylencarbonats enthält;
d. Einspeisen des zyklischen Alkylencarbonat-Abflusses und der alkalischen Lauge in ein Trennmittel und Abtrennen von Wasser und flüchtigen Bestandteilen aus dem zyklischen Alkylencarbonat;
e. Wiedergewinnen des entwässerten zyklischen Alkylencarbonats und danach Verdampfen des entwässerten zyklischen Alkylencarbonats zum Abtrennen des zyklischen Alkylencarbonats aus hochsiedenden Stoffen und polymeren Feststoffen, und Wiedergewinnen einer zyklischen Alklyencarbonatfraktion aus denselben; und
f. ferner Trennen des verdampften entwässerten zyklischen Alkylencarbonats in eine zyklische Alkylenglykolfraktion mit hohem Dampfdruck und in eine zyklische Alkylencarbonatfraktion mit niedrigem Dampfdruck.

10. Das Verfahren gemäß Anspruch 9, enthaltend das Abscheiden von Wasser, um dessen Konzentration genügend zu verringern, so daß die Hydrolyse des zyklischen Alkylencarbonats zu Alklylenglykol im wesentlichen verhindert wird.

11. Das Verfahren gemäß Anspruch 9 oder 10, enthaltend das Wiedergewinnen des entwässerten zyklischen Alkylencarbonats und sodann Abdampfen des entwässerten zyklischen Alkylencarbonats von den darin enthaltenen polymeren Stoffen.

12. Das Verfahren gemäß Anspruch 11, enthaltend das Wiedergewinnen eines Vorlaufprodukts aus zyklischem Alkylencarbonat und eines Bodensatzprodukts aus Polymermaterial in Alkylencarbonat.

13. Das Verfahren gemäß einem beliebigen der obigen Ansprüche 11 bis 12, enthaltend das Einspeisen des verdampften, entwässerten zyklischen Alkylencarbonats in ein Fraktioniermittel, und ferner das Trennen des verdampften, entwässerten zyklischen Alklyencarbonats in eine Alkylenglykolfraktion mit höherem Dampfdruck und eine nnp Carbonatfraktion mit niedigerem Dampfdruck.

14. Das Verfahren gemäß Anspruch 13, enthaltend das Wiedergewinnen eines fraktionierten Produkts, im wesentlichen frei von polymeren Stoffen, mit einem Farbwert unter 20 APHA (mit Bezug auf den Platin-Kobalt-Standard).

15. Das Verfahren gemäß Anspruch 13, enthaltend das Wiedergewinnen eines behandelten Produkts enthaltend unter 0,050 Gew.% Wasser.

16. Das Verfahren gemäß einem beliebigen der obigen Ansprüche, in dem das zyklische Alkylencarbonat durch die folgende Formel dargestellt wird: 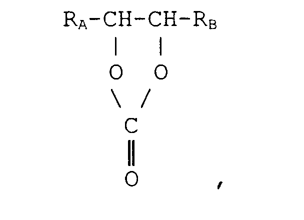 wobei Ra und Rb, einzeln oder beide, kurzkettige Alkylgruppen aus der Gruppe CH₃-(CH₂)ₙ- sein können, wobei n in Ra und Rb unabhängige Ganzzahlen von 0 bis 3, und Ra oder Rb, jedoch jeweils nur eines, -H sein kann.

17. Das Verfahren gemäß Anspruch 14, in dem das kurzkettige Alkylencarbonat Propylencarbonat ist.

18. Das Verfahren gemäß Anspruch 17, einschließlich das Abscheiden von Wasser, um dessen Konzentration genügend zu verringern, so daß die Hydrolyse des Propylencarbonats zu Propylenglykol im wesentlichen verhindert wird.

19. Das Verfahren gemäß Anspruch 16, enthaltend das Wiedergewinnen des entwässerten zyklischen Propylencarbonats und sodann Abdampfen des entwässerten Propylencarbonats, um das Propylencarbonat von den darin enthaltenen polymeren Stoffen zu trennen.

20. Das Verfahren gemäß Anspruch 19, enthaltend das Wiedergewinnen eines Vorlaufprodukts aus Propylencarbonat, und ein Bodensatzprodukt polymeren Stoffs eine lösbare Menge Propylencarbonat ist.

21. Das Verfahren gemäß einem beliebigen der obigen Ansprüche 18 bis 19, enthaltend das Einspeisen des verdampften, entwässerten Propylencarbonats in ein Fraktioniermittel, und ferner das Abtrennen des verdampften Propylencarbonats in eine Hochdampfdruck-Propylenglykolfraktion und eine Niederdampfdruck-Propylencarbonatfraktion.

22. Das Verfahren gemäß Anspruch 21, enthaltend das Wiedergewinnen eines fraktionierten Produkts, das im wesentlichen frei von polymeren Stoffen ist, mit einem Farbwert unter 20 APHA (mit Bezug auf den Platin-Kobalt-Standard).

23. Das Verfahren gemäß Anspruch 21, enthaltend das Wiedergewinnen eines im wesentlichen wasserfreien fraktionierten Produkts, enthaltend weniger als 0,030 Gew.% Wasser.

## Revendications

1. Un procédé de fabrication d'un boîtier pour circuit électronique comprenant les étapes consistant à déposer un produit photorésist sur le substrat du boîtier de circuit, à produire un motif d'image avec le photorésist, à révéler le photorésist, effectuer la mise en circuit du substrat et enlever le photorésist résiduel, dans lequel le solvant destiné au développement du produit résist et à l'enlèvement du produit résist ou à ces deux opérations est un carbonate d'alkylène cyclique et dans lequel le solvant gazeux est dégagé pendant la fabrication du boitier pour circuit électronique, ledit procédé comprend les étapes supplémentaires consistant à
a. éliminer du processus les fumées porteuses de solvant;
b. faire passer les fumées porteuses de solvant par un liquide aqueux alcalin afin d'en éliminer le solvant; et
c. récupérer l'air issu de l'élimination et qui est sensiblement exempt de solvant.

2. Le procédé selon la revendication 1, dans lequel ledit carbonate d'alkylène cyclique est constitué de carbonate de propylène.

3. Le procédé selon la revendication 2, dans lequel les fumées porteuses de carbonate de propylène contiennent une quantité supérieure à 100 parties par million de carbonate de propylène, et les gaz épurés contiennent moins de 100 parties par million de carbonate de propylène.

4. Le procédé selon la revendication 2 ou 3, dans lequel le liquide alcalin aqueux est une solution d'un hydroxyde de métal alcalin ou d'un sel d'un métal alcalin et d'un acide faible.

5. Le procédé selon la revendication 4, dans lequel l'hydroxyde de métal alcalin est de l'hydroxyde de sodium et la solution aqueuse d'hydroxyde de sodium contient moins de 10 pour-cent en poids d'hydroxyde de sodium.

6. Le procédé selon la revendication 4, dans lequel le liquide alcalin aqueux est un liquide alcalin aqueux en circulation comprenant :
a. la surveillance de la caractéristique électrolyte de la solution alcaline aqueuse en circulation; et
b. l'ajustement de la concentration de la solution alcaline aqueuse en circulation, par addition d'un électrolyte alcalin ou d'eau, en réponse à l'état de la solution.

7. Le procédé selon la revendication 6, comprenant la mesure du pH de la solution et l'ajustement de la concentration de la solution alcaline aqueuse en circulation, par addition d'un électrolyte alcalin ou d'eau, en réponse à la valeur du pH de la solution.

8. Le procédé selon la revendication 6, comprenant la mesure de la conductivité électrique de la solution et l'ajustement de la concentration en solution alcaline aqueuse en circulation, par addition d'électrolyte alcalin ou d'eau, en réponse à la conductivité de la solution.

9. Un procédé de récupération d'un carbonate d'alkylène cyclique venant d'un processus dans lequel le carbonate d'alkylène cyclique est un solvant utilisé pour l'enlèvement d'un matériau polymère organique depuis un substrat et formation de cette manière d'un courant d'effluent de carbonate d'alkylène cyclique et d'un courant d'effluent aqueux, ledit procédé comprenant les étapes consistant à :
a. récupérer l'effluent de carbonate d'alkylène cyclique gazeux du processus;
b. faire passer le carbonate d'alkylène cyclique gazeux par un liquide alcalin aqueux pour en éliminer le carbonate d'alkylène cyclique;
c. extraire (i) l'air épuré pratiquement exempt de carbonate d'alkylène cyclique, et (ii) une liqueur alcaline contenant le résidu du carbonate d'alkylène cyclique gazeux épuré;
d. fournir l'effluent de carbonate d'alkylène cyclique et la liqueur alcaline en direction d'un moyen de séparation et séparer l'eau et les produits volatiles vis-à-vis du carbonate d'alkylène cyclique;
e. récupérer le carbonate d'alkylène cyclique déshydraté, puis évaporer le carbonate d'alkylène cyclique déshydraté, afin de séparer le carbonate d'alkylène cyclique des matériaux et des solides polymères à point d'ébullition élevé, et récupération à partir de cela d'une fraction de carbonate d'alkylène cyclique, et
f. effectuer une séparation supplémentaire du carbonate d'alkylène cyclique déshydraté ayant été évaporé, en une fraction glycol alkylène cyclique à pression de vapeur élevée et une fraction de carbonate d'alkylène cyclique à pression de vapeur faible.

10. Le procédé selon la revendication 9, comprenant l'enlèvement de l'eau afin d'abaisser sa concentration suffisamment pour éviter pratiquement toute hydrolyse du carbonate d'alkylène cyclique donnant un glycol d'alkylène.

11. Le procédé selon la revendication 9 ou 10, comprenant la récupération du carbonate d'alkylène cyclique déshydraté puis l'évaporation du carbonate d'alkylène cyclique déshydraté vis-à-vis des matériaux polymères contenus.

12. Le procédé selon la revendication 11, comprenant la récupération d'un produit de tête de carbonate d'alkylène cyclique et un produit de queue, constitué d'un matériau polymère, dans le carbonate d'alkylène.

13. Le procédé selon l'une quelconque des revendications 11 à 12 ci-dessus, comprenant la fourniture du carbonate d'alkylène cyclique déshydraté évaporé à un moyen de fractionnement, et la séparation supplémentaire de carbonate d'alkylène cyclique déshydraté, évaporé en une fraction glycol alkylène à pression de vapeur élevée et en une fraction de carbonate nnp à pression de vapeur faible.

14. Le procédé selon la revendication 13, comprenant la récupération d'un produit fractionné, pratiquement exempt de matériaux polymères, ayant un indice colorimétrique inférieur à 20 APHA (référence au standard platine-cobalt).

15. Le procédé selon la revendication 13, comprenant la récupération des produits fractionnés contenant moins de 0,050 pour-cent en poids d'eau.

16. Le procédé selon l'une quelconque des revendications ci-dessus, dans lequel le carbonate d'alkylène cyclique est représenté par la formule 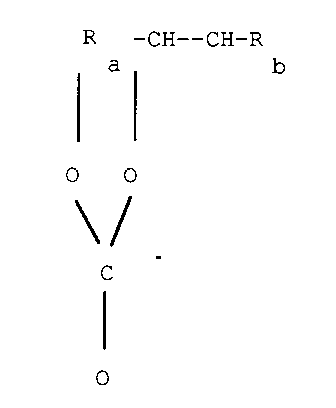 dans laquelle un ou les deux produits que sont Ra et Rb sont des groupes alkyles à chaîne courte choisis dans le groupe composé de CH3-(H2)n-, dans lequel n et Ra et Rb sont des entiers indépendants, compris dans la plage allant de 0 à 3 et l'un des produits que sont Ra et Rb pouvant être - H.

17. Le procédé selon la revendication 14, dans lequel le carbonate d'alkylène à chaîne courte est du carbonate de propylène.

18. Le procédé selon la revendication 17, comprenant l'enlèvement de l'eau afin d'abaisser sa concentration suffisamment pour pratiquement éviter toute hydrolyse du carbonate de propylène donnant du propylène glycol.

19. Le procédé selon la revendication 16, comprenant la récupération du carbonate de propylène déshydraté, puis l'évaporation du carbonate de propylène déshydraté pour séparer le carbonate de propylène des matériaux polymère contenus.

20. Le procédé selon la revendication 19, comprenant la récupération d'un produit de tête constitué de carbonate de propylène et d'un produit de queue constitué d'un matériau polymère, en une quantité solubilisante de carbonate de propylène.

21. Le procédé selon l'une quelconque des revendications 18 à 19, comprenant la fourniture du carbonate de propylène déshydraté évaporé à un moyen de fractionnement, et une séparation supplémentaire du produit évaporé pour donner une fraction de glycol de propylène à pression de vapeur élevée et une fraction de carbonate de propylène à pression de vapeur faible.

22. Le procédé selon la revendication 21, comprenant la récupération d'un produit fractionné pratiquement exempt de matériaux polymères, ayant un indice colorimétrique inférieur à 20 APHA (référence au standard platine-cobalt).

23. Le procédé selon la revendication 1, comprenant la récupération d'un produit fractionné pratiquement exempt d'eau, contenant moins de 0,030 pour-cent en poids d'eau.
